# FASCICULE DE BREVET EUROPEEN

(11) **EP 1 565 921 B1**
(45) Date de publication et mention de la délivrance du brevet: **26.07.2006**
(21) Numéro de dépôt: 03786073.1
(22) Date de dépôt: 27.11.2003
(51) Int. Cl.: H01H 59/00

(54) **MICRO-COMMUTATEUR ELECTROSTATIQUE POUR COMPOSANT A FAIBLE TENSION D'ACTIONNEMENT**
MIKROMECHANISCHER ELEKTROSTATISCHER SCHALTER MIT NIEDRIGER BETÄTIGUNGSSPANNUNG
ELECTROSTATIC MICROSWITCH FOR LOW-VOLTAGE-ACTUATION COMPONENT

(30) Priorité: 28.11.2002 FR 0214946
(43) Date de publication de la demande: 24.08.2005
(73) Titulaire: COMMISSARIAT A L'ENERGIE ATOMIQUE, 75752 Paris Cédex 15 (FR)
(72) Inventeur: ROBERT, Philippe, F-38100 GRENOBLE (FR)
(74) Mandataire: Poulin, Gérard
(86) Numéro de dépôt international: PCT/FR2003/050137
(87) Numéro de publication internationale: WO 2004/051687

(56) Documents cités:
- DE-A- 19 800 189
- US-A1- 2002 005 341
- US-B1- 6 307 169
- YAO J J: "RF MEMS from a device perspective" JOURNAL OF MICROMECHANICS AND MICROENGINEERING, DEC. 2000, IOP PUBLISHING, UK, vol. 10, no. 4, décembre 2000 (2000-12), pages R9-38, XP002255008 ISSN: 0960-1317 cité dans la demande
- YAO J J ET AL: "A SURFACE MICROMACHINES MINIATURE SWITCH FOR TELECOMMUNICATIONS APPLICATIONS WITH SIGNAL FREQUENCES FROM DC UP TO 4 GHZ" INTERNATIONAL CONFERENCE ON SOLID-STATE SENSORS AND ACTUATORS AND EUROSENSORS, XX, XX, vol. 2, 25 juin 1995 (1995-06-25), pages 384-387, XP000646268 cité dans la demande
- PONCHAK G E ET AL: "FINITE GROUND COPLANAR WAVEGUIDE SHUNT MEMS SWITCHES FOR SWITCHED LINE PHASE SHIFTERS" 30TH EUROPEAN MICROWAVE CONFERENCE PROCEEDINGS. PARIS, OCT. 3 - 5, 2000, PROCEEDINGS OF THE EUROPEAN MICROWAVE CONFERENCE, LONDON: CMP, GB, vol. 1 OF 3 CONF. 30, 3 octobre 2000 (2000-10-03), pages 252-255, XP001060741 cité dans la demande
- T-C NGUYEN C: "COMMUNICATIONS APPLICATIONS OF MICROELECTROMECHANICAL SYSTEMS" SENSORS EXPO 1998, 19 mai 1998 (1998-05-19), pages 447-455, XP002190275 san jose Extrait de l'Internet: <URL:http://www.eecs.umich.edu/~ctnguyen/s e98.pdf> [extrait le 2002-02-14] cité dans la demande

## Description

### DOMAINE TECHNIQUE

L'invention concerne un micro-commutateur électrostatique à grande fiabilité de fonctionnement et adapté aux composants à faible tension d'actionnement. Sous le terme de micro-commutateur, on inclut les micro-relais, les actionneurs de type MEMS (pour "Micro-Electro-Mechanical-System) et les actionneurs haute fréquence.

### ETAT DE LA TECHNIQUE ANTERIEURE

L'article "RF MEMS from a device perspective" de J. Jason Yao, paru dans J. Micromech. Microeng. 10(2000), pages R9 à R38, récapitule les progrès récents accomplis dans le domaine des MEMS pour des applications hautes fréquence.

Les composants haute fréquence ou RF pour la téléphonie mobile se voient imposer le cahier des charges suivants :
- tension d'alimentation inférieure à 5 V,
- isolation supérieure à 30 dB,
- perte d'insertion inférieure à 0,3 dB,
- fiabilité pour un nombre de cycles supérieur à 10⁹,
- dimensions inférieures à 0,05 mm².

Les micro-commutateurs sont très largement utilisés dans le domaine des communications : dans le routage des signaux, les réseaux d'accord d'imdépances, l'ajustage de gain d'amplificateurs, etc... En ce qui concerne les bandes de fréquences des signaux à commuter, ces fréquences sont comprises entre quelques MHz et plusieurs dizaines de GHz.

Classiquement, pour ces circuits RF, on utilise des commutateurs issus de la microélectronique, qui permettent une intégration avec l'électronique des circuits et qui ont un faible coût de fabrication. En termes de performances, ces composants sont par contre assez limités. Ainsi, des commutateurs de type FET en silicium peuvent commuter des signaux de forte puissance à basse fréquence mais pas à haute fréquence. Les commutateurs de type MESFET en GaAs ou les diodes PIN fonctionnent bien à haute fréquence mais uniquement pour des signaux de faibles niveaux. Enfin, d'une manière générale, au-delà de 1 GHz, tous ces commutateurs micro-électroniques présentent une perte d'insertion importante (classiquement autour de 1 à 2 dB) à l'état passant et une isolation assez faible à l'état ouvert (-20 à -25 dB). Le remplacement de composants conventionnels par des micro-commutateurs MEMS est par conséquent prometteur pour ce type d'application.

De par leur conception et leur principe de fonctionnement, les commutateurs MEMS présentent les caractéristiques suivantes :
- faibles pertes d'insertion (typiquement inférieures à 0,3 dB),
- isolation importante du MHz au millimétrique (typiquement supérieure à -30 dB),
- faible consommation,
- pas de non-linéarité de réponse.

On distingue deux types de contact pour ces micro-commutateurs MEMS.

L'un de ces types de contact est le commutateur à contact ohmique décrit dans l'article "RF MEMS from a device perpective" de J. Jason Yao cité ci-dessus et dans l'article "A Surface Micromachined Miniature Switch For Telecommunications Applications with Signal Frequencies From DC up to 4 GHz" de J. Jason Yao et M. Franck Chang, paru dans la revue Transducers'95, Eurosensors IX, pages 384 à 387. Dans ce type de contact, les deux pistes RF sont mises en contact par un court-circuit (contact métal-métal). Ce type de contact est adapté aussi bien pour les signaux continus que pour les signaux haute fréquence (supérieure à 10 GHz).

L'autre type de contact est le commutateur capacitif décrit dans l'article "RF MEMS From a device perspective" de J. Jason Yao cité ci-dessus et dans l'article "Finite Ground Coplanar Waveguide Shunt MEMS Switches for Switched Line Phase Shifters" de George E. Ponchak et al., paru dans 30th European Microwave Conference, Paris 2000, pages 252 à 254. Dans ce type de contact, une couche d'air est ajustée de manière électromécanique pour obtenir une variation de capacité entre l'état fermé et l'état ouvert. Ce type de contact est particulièrement bien adapté aux hautes fréquences (supérieures à 10 GHz) mais inadéquat aux basses fréquences.

Dans l'état de l'art, on distingue deux grands principes d'actionnement pour les commutateurs MEMS : les commutateurs à actionnement thermique et les commutateurs à actionnement électrostatique.

Les commutateurs à actionnement thermique présentent l'avantage d'une faible tension d'actionnement. Par contre, ils présentent les inconvénients suivants : consommation excessive (surtout dans le cas d'applications en téléphonie mobile), vitesse de commutation faible (à cause de l'inertie thermique) et technologie souvent lourde.

Les commutateurs à actionnement électrostatique présentent les avantages d'une vitesse de commutation rapide et d'une technologie généralement simple. Par contre, ils présentent l'inconvénient dû à des problèmes de fiabilité. Ce point est particulièrement sensible dans le cas de micro-commutateurs électrostatiques à faible tension d'actionnement (possibilité d'un collage des structures).

Le problème du collage des commutateurs à actionnement électrostatique est crucial. Ce problème est signalé notamment dans l'article de George E. Ponchak et al. cité ci-dessus et dans l'article "Communications Applications of Microelectromechanical Systems" de Clark T.-C. Nguyen, paru dans Proceedings, 1998 Sensors Expo, San Jose, CA, 19 au 21 mai 1998, pages 447 à 455.

Les micro-commutateurs électrostatiques de l'état de l'art présentent une électrode mobile d'actionnement isolée de l'électrode fixe par une couche diélectrique qui permet d'éviter tout court-circuit lors du basculement du micro-commutateur. Cette couche diélectrique, enserrée dans la capacité mobile d'actionnement n'est jamais parfaite. Elle comporte des défauts qui sont à l'origine d'un piégeage de charges dans la couche. Ces charges qui s'accumulent dans le diélectrique peuvent à terme engendrer une défaillance du composant (collage de la poutre ou nécessité d'une tension d'actionnement de plus en plus importante au cours des cycles de commutations).

Ce phénomène est accentué dans le cas des micro-commutateurs à faible tension d'actionnement où, pour atteindre les tensions de commutation généralement requises (classiquement supérieures ou égales à 5 volts), les concepteurs utilisent des structures mobiles présentant une raideur mécanique faible, c'est-à-dire une force de rappel élastique qui s'avère insuffisante au regard des forces électrostatiques parasites amenés par ce piégeage de charges, et qui conduit bien souvent au collage des micro-commutateurs au bout de 10⁴ à 10⁵ cycles, soit bien en dessous des spécifications généralement requises (supérieures à 10⁹ cycles).

Une manière simple d'éviter le piégeage de charges serait d'utiliser une poutre métallique. Il apparaît alors un risque important de court-circuit de cette poutre sur l'électrode d'actionnement, notamment dans le cas de micro-commutateurs à faible tension de commutation qui présentent une faible raideur mécanique. Pour remédier à ce problème de court-circuit, on peut envisager de placer des butées diélectriques de faibles dimensions sur les électrodes d'actionnement, le piégeage de charges localisé aux seules butées ne devant pas perturber le fonctionnement du micro-commutateur. Un tel micro-commutateur est décrit dans le document US 2002/0005341 A1. Le problème réside cette fois dans le risque important d'une mise en butée de la poutre sans contact au niveau des pistes conductrices à connecter.

### EXPOSÉ DE L'INVENTION

La présente invention a été conçue pour remédier aux inconvénients présentés par les dispositifs de l'art antérieur.

Elle a pour objet un micro-commutateur électrostatique destiné à raccorder électriquement au moins deux pistes électriquement conductrices disposées sur un support isolant, le raccord électrique entre les deux pistes conductrices se faisant par des moyens conducteurs prévus en partie centrale de moyens déformables aptes à se déformer par rapport au support, sous l'action d'une force électrostatique générée par des électrodes de commande réparties en vis-à-vis sur les moyens déformables et le support pour former des moyens capacitifs autour desdits moyens conducteurs, lesdits moyens conducteurs réalisant le raccord électrique entre les deux pistes conductrices lorsque les moyens déformables sont déformés jusqu'à venir en contact avec les extrémités des pistes conductrices, caractérisé en ce que :
- l'électrode ou les électrodes de commande sur le support ou l'électrode ou les électrodes de commande sur les moyens déformables est (sont) associée(s) à des butées d'isolation prévues pour éviter tout court-circuit entre électrodes desdits moyens capacitifs au cours de la déformation des moyens déformables,
- la distance séparant les moyens déformables des extrémités des pistes conductrices est inférieure ou égale à la distance séparant les butées d'isolation associées à une électrode ou aux électrodes de commande de l'électrode ou des électrodes de commande située(s) en vis-à-vis.

Les moyens déformables peuvent être choisis parmi une membrane et une poutre.

Selon une première variante de réalisation, les moyens déformables sont en matériau conducteur et constituent une électrode de commande et les moyens conducteurs.

Selon une deuxième variante de réalisation, les moyens déformables sont en matériau isolant et supportent des parties conductrices pour constituer une électrode ou des électrodes de commande et un plot conducteur pour constituer lesdits moyens conducteurs.

Chaque extrémité de piste conductrice peut être formée sur un bossage du support.

Les moyens conducteurs peuvent être en dépassement par rapport aux moyens déformables.

Les butées d'isolation peuvent être des plots en matériau isolant supportés par une ou des électrodes de commande.

Les butées d'isolation peuvent être des parties proéminentes d'une électrode ou d'électrodes de commande située(s) en regard de parties isolantes situées au sein ou près d'une électrode ou d'électrodes de commande en vis-à-vis.

Si le micro-commutateur est du type à contact ohmique, les moyens conducteurs sont aptes à être mis directement en contact électrique avec les extrémités des pistes conductrices.

Si le micro-commutateur est du type capacitif, une couche de matériau isolant est interposée entre les moyens conducteurs et les extrémités des pistes conductrices.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1 et 2 sont des vues en coupe, respectivement longitudinale et de dessus, d'une première variante de micro-commutateur selon l'invention,
- la figure 3 est une vue en coupe longitudinale d'une deuxième variante de micro-commutateur selon l'invention,
- la figure 4 est une vue en coupe longitudinale d'une troisième variante de micro-commutateur selon l'invention,
- la figure 5 est une vue en coupe longitudinale d'une quatrième variante de micro-commutateur selon l'invention,
- la figure 6 est une vue en coupe longitudinale d'une cinquième variante de micro-commutateur selon l'invention,
- les figures 7A à 7H sont des vues en coupe longitudinale d'un procédé de réalisation du micro-commutateur selon la cinquième variante de l'invention.

### DESCRIPTION DETAILLEE DE MODES DE REALISATION DE L'INVENTION

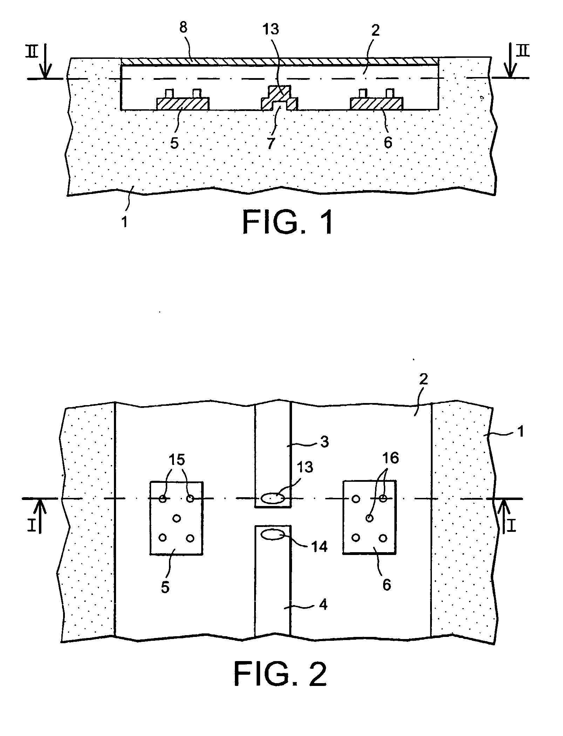

Les figures 1 et 2 sont des vues en coupe, respectivement longitudinale et de dessus, d'une première variante de micro-commutateur selon l'invention. La figure 1 est une vue selon la coupe I-I de la figure 2 et la figure 2 est une vue selon la coupe II-II de la figure 1.

Le micro-commutateur est réalisé dans une partie isolante d'un substrat 1. Un évidement 2 a été réalisé à partir d'une face du substrat 1. La partie centrale du fond de l'évidement supporte deux pistes conductrices 3 et 4 à raccorder électriquement. Le fond de l'évidement supporte également des électrodes de commande inférieures 5 et 6 situées de part et d'autre des pistes conductrices 3 et 4 et dont les connexions électriques n'ont pas été représentées.

Les extrémités 13 et 14 des pistes conductrices 3 et 4 sont situées en regard l'une de l'autre. Elles sont formées sur un bossage présent sur le fond de l'évidement. Seul le bossage 7 est visible sur la figure 1.

Les électrodes de commande inférieures 5 et 6 supportent des plots en matériau isolant, respectivement 15 et 16. Ces plots isolants sont de faibles dimensions par rapport aux dimensions des électrodes.

Une poutre métallique 8, encastrée à ses deux extrémités, est suspendue au-dessus de l'évidement 2. Elle est située en regard des électrodes de commande inférieures 5 et 6 et des extrémités 13 et 14 des pistes conductrices 3 et 4. La poutre conductrice 8 constitue à la fois des électrodes de commande supérieures et un plot de contact ohmique pour les extrémités 13 et 14 des pistes conductrices.

Les plots isolants 15 ou 16 d'une même électrode de commande inférieure 5 ou 6 sont écartés entre eux d'une distance suffisamment faible pour éviter tout risque de déformation de la poutre 8 pouvant créer un court-circuit au niveau des électrodes de commande, c'est-à-dire entre la poutre conductrice 8 et l'électrode 5 d'une part et entre la poutre conductrice 8 et l'électrode 6 d'autre part. L'écart maximal entre deux plots isolants d'une même électrode de commande inférieure est établi en fonction de la hauteur des plots isolants, de la rigidité de la poutre et la tension électrique de commande.

La distance séparant la poutre conductrice 8 des extrémités 13 et 14 des pistes conductrices 3 et 4 est inférieure ou égale à la distance séparant les plots isolants 15 et 16 de la poutre conductrice 8.

Sous l'effet d'une tension de commande appropriée appliquée entre la poutre conductrice 8 et les électrodes 5 et 6, la poutre 8 fléchit jusqu'à venir en contact avec les extrémités des pistes conductrices.

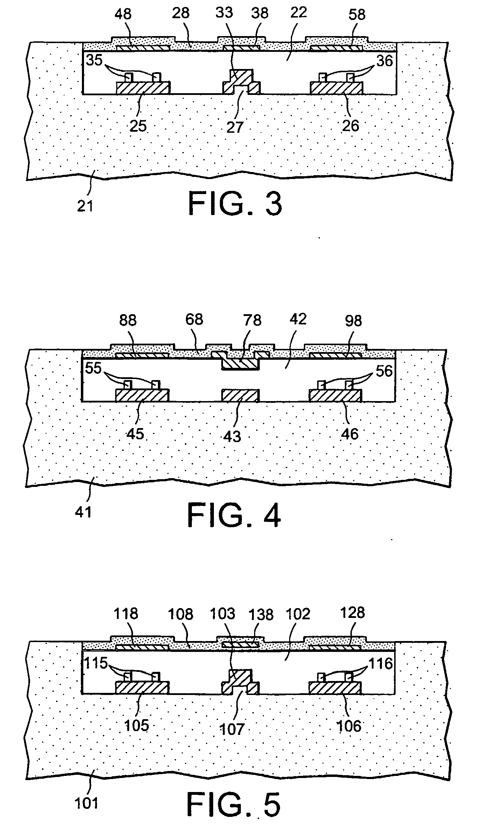

La figure 3 est une vue en coupe longitudinale d'une deuxième variante de micro-commutateur selon l'invention.

On reconnaît sur cette figure la partie isolante d'un substrat 21, un évidement 22, des électrodes de commande inférieures 25 et 26 pourvues de plots isolants respectivement 35 et 36, l'un des bossages 27 et l'une des extrémités 33 de pistes conductrices. Ces éléments sont similaires aux mêmes éléments de la première variante de micro-commutateur selon l'invention.

La deuxième variante de micro-commutateur selon l'invention se distingue de la première variante par la nature de la poutre 28 qui est en matériau isolant. La face de la poutre 28 tournée vers l'évidement 22 supporte un plot conducteur 38 situé en regard des extrémités des pistes conductrices et des électrodes de commande supérieures 48 et 58 associées respectivement aux électrodes de commande inférieures 25 et 26.

Sous l'effet d'une tension de commande appropriée appliquée entre les électrodes de commande supérieures 48 et 58 et les électrodes de commande inférieures 25 et 26, la poutre 28 fléchit jusqu'à ce que le plot conducteur 38 vienne en contact avec les extrémités des pistes conductrices.

La distance séparant le plot conducteur 38 des extrémités des pistes conductrices est inférieure ou égale à la distance séparant les plots isolants 35 et 36 des électrodes respectives 48 et 58.

La figure 4 est une vue en coupe longitudinale d'une troisième variante de micro-commutateur selon l'invention.

On reconnaît sur cette figure, par rapport à la figure 3, la partie isolante d'un substrat 41, un évidement 42 et des électrodes de commande inférieures 45 et 46 pourvues de plots isolants respectivement 55 et 56. On reconnaît également une poutre 68 en matériau isolant dont la face tournée vers l'évidement supporte un plot conducteur 78 situé en regard des extrémités des pistes conductrices et des électrodes de commande supérieures 88 et 98 associées respectivement aux électrodes de commande inférieures 45 et 46.

La troisième variante de micro-commutateur selon l'invention se distingue de la deuxième variante en ce que les extrémités des pistes conductrices (seule l'extrémité 43 est montrée) ne sont pas formées sur des bossages mais sur le fond de l'évidement. Par contre, le plot conducteur 78 est en dépassement par rapport à la face de la poutre tournée vers l'évidement de sorte que la distance séparant le plot conducteur 78 des extrémités des pistes conductrices est inférieure ou égale à la distance séparant les plots isolants 55 ou 56 de l'électrode de commande supérieure 88 ou 98.

Sous l'effet d'une tension de commande appropriée appliquée entre les électrodes de commande supérieures 88 et 98 et les électrodes de commande inférieures 45 et 46, la poutre 68 fléchit jusqu'à ce que le plot conducteur 78 vienne en contact avec les extrémités des pistes conductrices.

La figure 5 est une vue en coupe longitudinale d'une quatrième variante de micro-commutateur selon l'invention.

On reconnaît sur cette figure, par rapport à la figure 3, la partie isolante d'un substrat 101, un évidement 102, des électrodes de commande inférieures 105 et 106 pourvues de plots isolants respectivement 115 et 116, l'un des bossages 107 et l'une des extrémités 103 de pistes conductrices. On reconnaît également une poutre 108 en matériau isolant dont la face tournée vers l'évidement supporte des électrodes de commande supérieures 118 et 128 associées respectivement aux électrodes de commande inférieures 105 et 106.

La quatrième variante de micro-commutateur selon l'invention se distingue de la deuxième variante en ce que la poutre isolante 108 intègre le plot conducteur 138. De ce fait, une fine couche isolante est interposée entre le plot conducteur 138 et les extrémités des pistes conductrices, le micro-commutateur étant du type capacitif.

Sous l'effet d'une tension de commande appropriée appliquée entre les électrodes de commande supérieures 118 et 128 et les électrodes de commande inférieures 105 et 106, la poutre 108 fléchit jusqu'à venir en contact mécanique avec les extrémités des pistes conductrices établissant ainsi une liaison de type capacitif entre les pistes conductrices.

La distance séparant la poutre 108 des extrémités des pistes conductrices est inférieure ou égale à la distance séparant les plots isolants 115 et 116 des électrodes respectives 118 et 128.

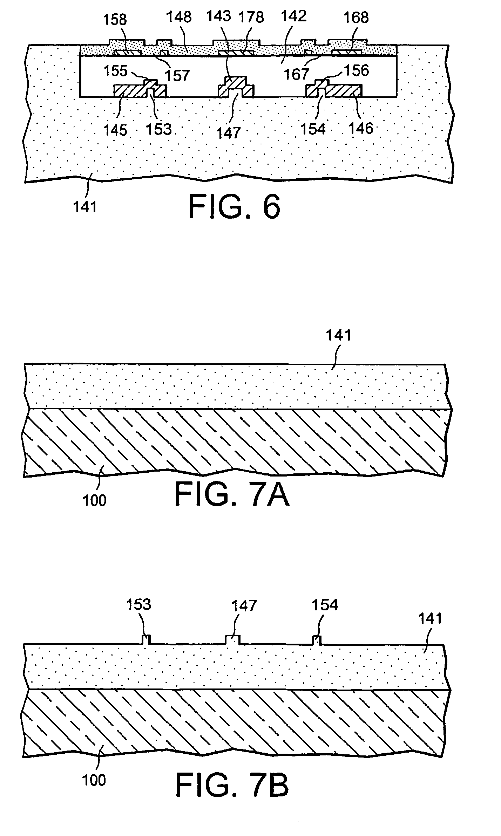

La figure 6 est une vue en coupe longitudinale d'une cinquième variante de micro-commutateur selon l'invention.

On reconnaît sur cette figure, par rapport à la figure 3, la partie isolante d'un substrat 141, un évidement 142, des électrodes de commande inférieures 145 et 146 et l'une des extrémités 143 de pistes conductrices formées sur un bossage 147. On reconnaît également une poutre 148 en matériau isolant dont la face tournée vers l'évidement supporte un plot conducteur central 178 et des électrodes de commande supérieures 158 et 168 associées respectivement aux électrodes 145 et 146.

La cinquième variante de micro-commutateur selon l'invention se distingue de la deuxième variante en ce que les électrodes de commande inférieures 145 et 146 sont pourvues de plots respectivement 155 et 156 du même matériau que celui des électrodes. Les plots 155 et 156 sont provoqués par la présence de bossages, respectivement 153 et 154, prévus sur le fond de l'évidement. Les plots 155 et 156 sont répartis sur les électrodes 145 et 146 selon les mêmes critères que les plots isolants des variantes précédentes.

En vis-à-vis des plots 155 et 156, les électrodes de commande supérieures 158 et 168 sont percées d'ouvertures comblées de matériau diélectrique formant des pastilles isolantes 157 et 167 afin d'éviter un éventuel court-circuit avec ces électrodes.

La distance séparant le plot conducteur 178 des extrémités des pistes conductrices est inférieure ou égale à la distance séparant les plots 155 et 156 des pastilles isolantes respectives 157 et 167.

Les figures 7A à 7H sont des vues en coupe longitudinale d'un procédé de réalisation du micro-commutateur selon la cinquième variante de réalisation.

La figure 7A montre un substrat de silicium 100 recouvert d'une couche diélectrique 141 qui a été formée sur le substrat 100. La couche 141 peut être en Si₃N₄ ou en SiO₂ et avoir une épaisseur de 2,4 µm.

La couche 141 est micro-usinée par lithogravure pour former à sa surface un bossage central 147 compris entre d'autres bossages 153 et 154 (voir la figure 7B). Un seul bossage 153 et un seul bossage 154 sont représentés. La hauteur des bossages peut être de 0,3 µm, ce qui réduit l'épaisseur de la couche 141 à 2,1 µm.

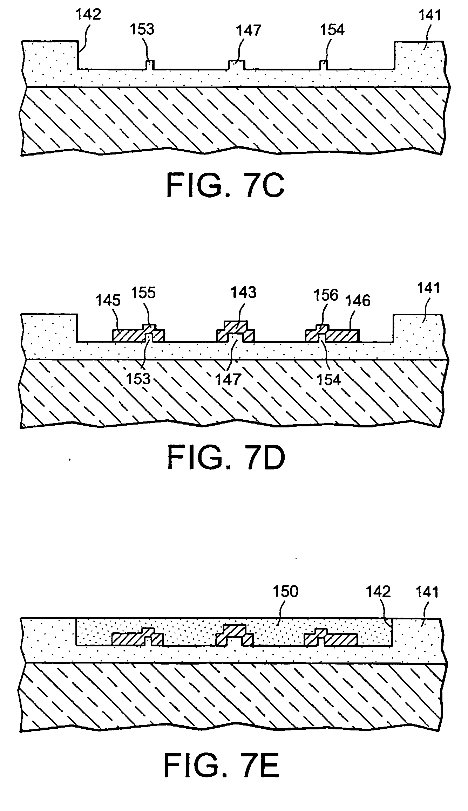

La couche 141 pourvue de ses bossages est encore micro-usinée par lithogravure pour réaliser un évidement 142 comme le montre la figure 7C. Les bossages 147, 153 et 154 sont reportés au fond de l'évidement 142. La profondeur de l'évidement peut être de 0,5 µm. Cette même étape de lithogravure permet de réaliser des logements (non représentés) destinés à recevoir des connexions électriques aux futures électrodes de commande inférieures, aux pistes conductrices et pour le plan de masse.

Les pistes conductrices et les électrodes de commande inférieures sont ensuite réalisées par dépôt d'une couche métallique (par exemple en or, en cuivre ou en aluminium) suivi d'une lithograwre. La figure 7D montre l'une des extrémités 143 d'une piste conductrice, formée sur le bossage 147 et les électrodes de commande inférieures 145 et 146. L'électrode 145 comprend des plots 155 reproduisant la forme des bossages 153. L'électrode 146 comprend des plots 156 reproduisant la forme des bossages 154. L'épaisseur de l'extrémité 143 peut être de 1,2 µm. L'épaisseur des électrodes de commande inférieures peut être de 0,9 µm.

Une couche sacrificielle 150, par exemple en polyimide, est ensuite déposée dans l'évidement 142. La couche 150 est planarisée jusqu'à atteindre la face supérieure de la couche 141 comme le montre la figure 7E.

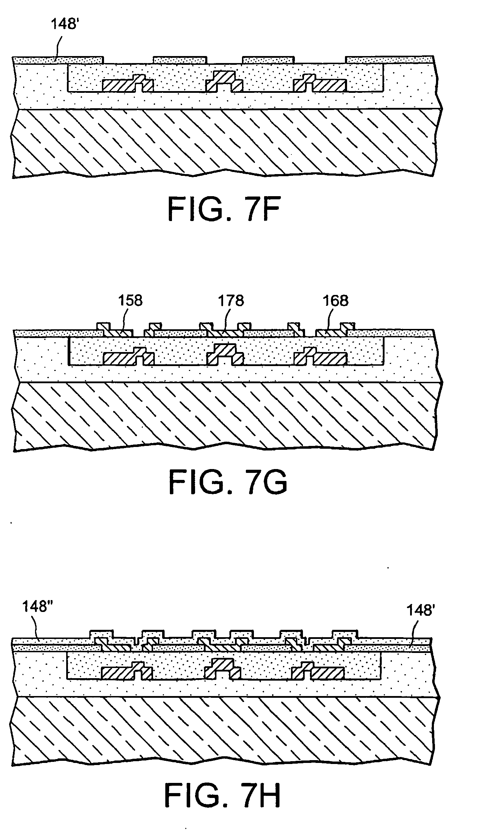

Une première couche diélectrique 148', par exemple en Si₃N₄ ou en SiO₂, est ensuite déposée sur la surface planarisée de la structure précédente (voir la figure 7F). Cette première couche diélectrique peut faire 0,15 µm d'épaisseur. Cette couche est lithogravée aux endroits prévus pour l'emplacement des électrodes de commande supérieures et du plot conducteur.

Une couche métallique (par exemple en or sur une couche d'accrochage en Cr, en cuivre ou en aluminium) est ensuite déposée sur la première couche diélectrique 148'. Par lithogravure de cette couche, ou réalise les électrodes de commande supérieures 158 et 168 et le plot conducteur 178. C'est ce que montre la figure 7G. Les connexions électriques avec ces éléments conducteurs sont réalisées lors de la même opération.

Une deuxième couche diélectrique 148" est déposée sur la structure obtenue précédemment comme le montre la figure 7H. Par lithogravure, des ouvertures (non représentées) sont réalisées dans l'épaisseur des deux couches diélectriques 148' et 148" pour révéler la couche sacrificielle 150 et pour la reprise de contact sur les électrodes.

La couche sacrificielle est alors éliminée par gravure sélective à partir d'ouvertures réalisées précédemment. On obtient la structure représentée à la figure 6 où la partie isolante de la poutre est représentée sous la référence globale 148.

L'invention permet de limiter à des zones très réduites (les butées d'isolation) le piégeage des charges et donc l'effet de collage. Elle permet d'éviter tout risque de court-circuit entre électrodes de commande du fait de la présence de ces butées d'isolation. Elle assure un bon contact du micro-commutateur du fait que la distance séparant les moyens déformables des extrémités des pistes conductrices est inférieure ou égale à la distance séparant les butées d'isolation associées aux électrodes de commande des électrodes de commande situées en vis-à-vis.

La vitesse de commutation des micro-commutateurs est fonction de l'amortissement visqueux de la poutre (ou de la membrane). Cet amortissement est inversement proportionnel à la distance (ou entrefer) entre la poutre et les pistes conductrices et électrodes de commande inférieures et est aussi inversement proportionnel aux surfaces en regard. Ainsi, plus la poutre fléchie et se rapproche des pistes à commuter, plus l'amortissement augmente et tend à retenir le déplacement. Ce qui se traduit par une augmentation du temps de commutation. Dans le cas de la présente invention, les zones où l'amortissement et important (zone d'entrefer faible) se limitent aux butées (sur les électrodes d'actionnement) et aux bossages (au niveau du contact). Les surfaces en jeu sont par conséquent extrêmement réduites par rapport aux micro-commutateurs MEMS de l'état de l'art. Le temps de commutation sera par conséquent optimisé.

## Revendications

1. Micro-commutateur électrostatique destiné à raccorder électriquement au moins deux pistes électriquement conductrices (3, 4) disposées sur un support isolant (1, 21, 41, 101, 141), le raccord électrique entre les deux pistes conductrices se faisant par des moyens conducteurs (38, 78, 138, 178) prévus en partie centrale de moyens déformables (8, 28, 68, 108, 148) aptes à se déformer par rapport au support, sous l'action d'une force électrostatique générée par des électrodes de commande réparties en vis-à-vis sur les moyens déformables et le support pour former des moyens capacitifs autour desdits moyens conducteurs, lesdits moyens conducteurs réalisant le raccord électrique entre les deux pistes conductrices lorsque les moyens déformables sont déformés jusqu'à venir en contact avec les extrémités (13, 14 ; 33 ; 43 ; 103 ; 143) des pistes conductrices, dans lequel
l'électrode ou les électrodes de commande sur le support (5, 6 ; 25, 26 ; 45, 46 ; 105, 106 ; 145, 146) ou l'électrode ou les électrodes de commande sur les moyens déformables (48, 58 ; 88, 98 ; 118, 128 ; 158, 168) est sont associées à des butées d'isolation prévues pour éviter tout court-circuit entre électrodes desdits moyens capacitifs au cours de la déformation des moyens déformables, **caractérisé en ce que** :
- la distance séparant les moyens déformables des extrémités des pistes conductrices est inférieure ou égale à la distance séparant les butées d'isolation associées à une électrode ou aux électrodes de commande de l'électrode ou des électrodes de commande située (s) en vis-à-vis, et **en ce que**
- les butées d'isolation sont des parties proéminentes (155, 156) d'une électrode ou d'électrodes de commande (145, 146) situées en regard de parties isolantes (157, 167) situées au sein ou près d'une électrode ou d'électrodes de commande (158, 168) en vis-à-vis.

2. Micro-commutateur selon la revendication 1, **caractérisé en ce que** les moyens déformables sont choisis parmi une membrane et une poutre (8, 28, 68, 108, 148).

3. Micro-commutateur selon l'une des revendications 1 ou 2, **caractérisé en ce que** les moyens déformables (8) sont en matériau conducteur et constituent une électrode de commande et les moyens conducteurs.

4. Micro-commutateur selon l'une des revendications 1 ou 2, **caractérisé en ce que** les moyens déformables (28, 68, 108, 148) sont en matériau isolant et supportent des parties conductrices pour constituer une électrode ou des électrodes de commande (48, 58 ; 88, 98 ; 118, 128 ; 158, 168) et un plot conducteur (38, 78, 138, 178) pour constituer lesdits moyens conducteurs.

5. Micro-commutateur selon l'une des revendications 1 ou 2, **caractérisé en ce que** chaque extrémité de piste conductrice est formée sur un bossage (7, 27, 107, 147) du support.

6. Micro-commutateur selon l'une des revendications 1 ou 2, **caractérisé en ce que** lesdits moyens conducteurs (78) sont en dépassement par rapport aux moyens déformables (68).

7. Micro-commutateur selon l'une quelconque des revendications 1 à 6, **caractérisé en ce que**, le micro-commutateur étant du type à contact ohmique, les moyens conducteurs (38, 78, 178) sont aptes à être mis directement en contact électrique avec les extrémités des pistes conductrices.

8. Micro-commutateur selon l'une quelconque des revendications 1 à 6, **caractérisé en ce que**, le micro-commutateur étant à contact capacitif, une couche de matériau isolant est interposée entre les moyens conducteurs (138) et les extrémités des pistes conductrices.

## Claims

1. An electrostatic microswitch intended to electrically connect at least two electrical strip conductors (3, 4) disposed on an insulating support (1, 21, 41, 101, 141), the two strip conductors being connected electrically by conducting means (38, 78, 138, 178) provided in the central part of deformable means (8, 28, 68, 108, 148) which can be deformed in relation to the support under the effect of an electrostatic force generated by control electrodes which are distributed facing one another on the deformable means and the support, so as to form capacitive means around said conducting means, said conductive means performing the electrical connection between the two strip conductors when the deformable means are deformed to contact the ends (13, 14; 33; 43; 103; 143) of the strip conductors, wherein the control electrode or the control electrodes on the support (5, 6; 25, 26; 45, 46; 105, 106; 145, 146) or the control electrode or control electrodes on the deformable means (48, 58; 88, 98; 118, 128; 158, 168) is or are associated with insulating stop elements provided in order to prevent a short-circuit between electrodes of said capacitive means during the deformation of the deformable means, **characterized in that** the distance between the deformable means and the ends of the strip conductors is less than or equal to the distance between the insulating stop elements associated with a control electrode or control electrodes of the control electrode or the control electrodes facing one another and **in that** the insulating stop elements are protruding parts (155, 156) of the control electrode(s) (145, 146) located opposite insulating parts (157, 167) located in or close to a control electrode or control electrodes (158, 168) facing one another.

2. A microswitch according to claim 1, **characterized in that** the deformable means are selected amongst a membrane and a beam (8, 28, 68, 108, 148).

3. A microswitch according to any of claims 1 or 2, **characterized in that** the deformable means 98) are made of a conductive material and constitute a control electrode and the conductive means.

4. A microswitch according to any of claims 1 or 2, **characterized in that** the deformable means (28, 68, 108, 148) are made of an insulating material and support conductive parts to constitute a control electrode or control electrodes (48, 58; 88, 98; 118, 128; 158, 168) and a conductive stud (38, 78, 138, 178) to constitute said conductive means.

5. A microswitch according to any of claims 1 or 2, **characterized in that** each strip conductor end is formed on a projection (7, 27, 107, 147) of the support.

6. A microswitch according to any of claims 1 or 2, **characterized in that** said conductive means (78) are protruding in relation to the deformable means (68).

7. A microswitch according to any one of claims 1 to 6, **characterized in that** the microswitch being of an ohmic contact type, the conductive means (38, 78, 178) can directly electrically contact the strip conductor ends.

8. A microswitch according to any one of claims 1 to 6, **characterized in that** the microswitch being of a capacitive contact type, an insulating material layer is interposed between the conductive means (138) and the strip conductor ends.

## Patentansprüche

1. Elektrostatischer Mikroschalter, dazu bestimmt, wenigstens zwei auf einem isolierenden Träger (1, 21, 41, 101, 141) angeordnete elektrische Leiterbahnen (3, 4) zu verbinden, wobei die elektrische Verbindung zwischen den beiden Leiterbahnen durch leitfähige Einrichtungen (38, 78, 138, 178) erfolgt, die im zentralen Teil von verformbaren Einrichtungen (8, 28, 68, 108, 148) vorgesehen sind, die fähig sind, sich in Bezug auf den Träger zu verformen unter der Wirkung einer elektrostatischen Kraft, erzeugt durch Steuerelektroden, die sich, verteilt auf den verformbaren Einrichtungen und dem Träger, so gegenüberstehen, dass sie um die genannten leitfähigen Einrichtungen herum kapazitive Einrichtungen bilden, wobei die genannten leitfähigen Einrichtungen die elektrische Verbindung zwischen den beiden Leiterbahnen herstellen, wenn die verformbaren Einrichtungen verformt werden bis sie Kontakt haben mit den Enden (13, 14; 33; 43; 103; 143) der Leiterbahnen, wobei der Steuerelektrode oder den Steuerelektroden (5, 6; 25, 26; 45, 46; 105, 106; 145, 146) auf dem Träger oder der Steuerelektrode oder den Steuerelektroden (48, 58;, 88, 98; 118, 128; 158, 168) auf den verformbaren Einrichtungen Isolationsanschläge zugeordnet sind, die dazu dienen, während der Verformung der verformbaren Einrichtungen jeglichen Kurzschluss zwischen Elektroden der genannten kapazitiven Einrichtungen zu verhindern,
**dadurch gekennzeichnet:**
- **dass** der Abstand, der die verformbaren Einrichtungen von den Enden der Leiterbahnen trennt, kleiner oder gleich dem Abstand ist, der die Isolationsanschläge trennt, die einer Steuerelektrode oder den Steuerelektroden oder der gegenüberstehenden Steuerelektrode oder gegenüberstehenden Steuerelektroden zugeordnet sind, und **dadurch**,
- **dass** die Isolationsanschläge vorstehende Teile (155, 156) einer Steuerelektrode oder von Steuerelektroden (145, 146) sind, die isolierenden Teilen (157, 167) gegenüberstehen, die sich innerhalb oder in der Nähe einer gegenüberstehenden Steuerelektrode oder gegenüberstehender Steuerelektroden (158, 168) befinden.

2. Mikroschalter nach Anspruch 1, **dadurch gekennzeichnet, dass** die verformbaren Einrichtungen ausgewählt werden zwischen einer Membran und einem Balken (8, 28, 68, 108, 148).

3. Mikroschalter nach einem der Ansprüche 1 oder 2, **dadurch gekennzeichnet, dass** die verformbaren Einrichtungen (8) aus leitfähigem Material sind und durch eine Steuerelektrode und leitfähige Einrichtungen gebildet werden.

4. Mikroschalter nach einem der Ansprüche 1 oder 2, **dadurch gekennzeichnet, dass** die verformbaren Einrichtungen (28, 68, 108, 148) aus isolierendem Material sind und leitfähige Teile, die eine Steuerelektrode oder Steuerelektroden (48, 58; 88, 98; 118, 128; 158, 168) bilden, sowie ein leitfähiges Kontaktelement (38, 78, 138, 178) tragen, um die genannten leitfähigen Einrichtungen zu bilden.

5. Mikroschalter nach einem der Ansprüche 1 oder 2, **dadurch gekennzeichnet, dass** jedes Leiterbahnende auf einem Höcker (7, 27, 107, 147) des Trägers ausgebildet ist.

6. Mikroschalter nach einem der Ansprüche 1 oder 2, **dadurch gekennzeichnet, dass** die genannten leitfähigen Einrichtungen (78) in Bezug auf die verformbaren Einrichtungen (68) vorstehen.

7. Mikroschalter nach einem der Ansprüche 1 bis 6, **dadurch gekennzeichnet, dass** der Mikroschalter mit ohmschem Kontakt funktioniert und die leitfähigen Einrichtungen (38, 78, 178) mit den Enden der Leiterbahnen in direkten elektrischen Kontakt gebracht werden können.

8. Mikroschalter nach einem der Ansprüche 1 bis 6, **dadurch gekennzeichnet, dass** der Mikroschalter mit kapazitivem Kontakt funktioniert, wobei sich zwischen den leitfähigen Einrichtungen (138) und den Enden der Leiterbahnen eine Schicht aus isolierendem Material befindet.
